# EUROPÄISCHE PATENTSCHRIFT

(11) **EP 2 094 123 B1**
(45) Veröffentlichungstag und Bekanntmachung des Hinweises auf die Patenterteilung: **17.08.2011**
(21) Anmeldenummer: 07818891.9
(22) Anmeldetag: 10.10.2007
(51) Int. Cl.: A44B 18/00

(54) **STRUKTURIERTE OBERFLÄCHE MIT SCHALTBARER HAFTFÄHIGKEIT**
STRUCTURED SURFACE WITH ADJUSTABLE ATTACHABILITY
SURFACE STRUCTURÉE À POUVOIR D'ADHÉRENCE COMMUTABLE

(30) Priorität: 25.10.2006 DE 102006050365
(43) Veröffentlichungstag der Anmeldung: 02.09.2009
(73) Patentinhaber: Max-Planck-Gesellschaft zur Förderung der Wissenschaften e.V., 80539 München (DE)
(72) Erfinder: DEL CAMPO BÈCARES, Aránzazu, 55128 Mainz (DE); ARZT, Eduard, 66123 Saarbrücken (DE)
(74) Vertreter: Hertz, Oliver
(86) Internationale Anmeldenummer: PCT/EP2007/008820
(87) Internationale Veröffentlichungsnummer: WO 2008/049517

(56) Entgegenhaltungen:
- EP-A- 1 422 439
- EP-A- 1 424 022
- EP-A- 1 424 023
- EP-A- 1 499 808
- WO-A-03/099951
- US-A1- 2004 194 261
- US-B1- 6 546 602

## Beschreibung

Die Erfindung betrifft eine strukturierte Oberfläche eines Festkörpers, die eine Vielzahl von Vorsprüngen aufweist, die eine Kontaktfläche mit einer vorbestimmten Haftfähigkeit bilden. Die Erfindung betrifft des weiteren ein mit einer derartigen strukturierten Oberfläche ausgestattetes Bauteil und Verfahren zur Modifizierung der strukturierten Oberfläche.

Es ist bekannt, dass verschiedene Tiere, wie z. B. Insekten oder Eidechsen die Fähigkeit haben, sich an beliebig orientierten Oberflächen aufzuhalten oder zu bewegen. Diese Fähigkeit wird durch eine Feinstruktur an den Füßen der Tiere ermöglicht. Die Feinstruktur verursacht zwischen den Fußflächen und einer angrenzenden Oberfläche relativ große Haftkräfte, welche die Gewichtskraft des Tieres übersteigen können.

Es ist bekannt, ähnlich zu der Erzeugung von Haftkräften in der Natur Festkörperoberflächen zu strukturieren, um deren Haftfähigkeit zu erhöhen. In WO 03/099951 A2 wird ein Verfahren zur Oberflächenmodifizierung eines Objektes beschrieben, bei dem auf der Oberfläche des Objektes eine Vielzahl von Vorsprüngen gebildet werden, deren freie Stirnflächen eine Kontaktfläche bilden. Die Kontaktfläche zeichnet sich im Vergleich zur unstrukturierten Oberfläche durch eine erhöhte Haftfähigkeit aus.

Für die Anwendung strukturierter Oberflächen mit erhöhter Haftfähigkeit in der Praxis besteht ein Interesse, die Haftfähigkeit in Abhängigkeit von den aktuellen Anforderungen einer konkreten Anwendung zu variieren. Beispielsweise soll ein Werkzeug mit einem Haftelement dazu verwendet werden, zuzunächst an einer ersten Position ein Werkstück zu erfassen, anschließend das Werkstück an eine zweite Position zu bewegen und schließlich das Werkstück an der zweiten Position freizugeben. Die Überwindung der Haftkräfte der strukturierten Oberfläche erforderte bisher die Ausübung zusätzlicher mechanischer Kräfte z. B. an dem Haftelement oder dem Werkstück, unter deren Wirkung die strukturierte Oberfläche vom angrenzenden Gegenstand abgehoben wird. Die Ausübung der zusätzlichen Trennkräfte stellt jedoch einen in der Regel unerwünschten Zusatzaufwand dar. Des weiteren können durch die Trennkräfte die strukturierte Oberfläche oder der angrenzende Gegenstand nachteilig beeinflusst, z. B. beschädigt werden.

Ein Klett-System mit einer Kombination von Haken- und Ösen-Elementen ist in EP 1 422 439 A1 beschrieben, bei dem die Haken-Elemente aus einem magnetorheologischen Elastomer gebildet sind, das in Abhängigkeit von einem äußeren Magnetfeld eine Änderung der Formorientierung und/oder der Biegsamkeit aufweist.

Der vorliegenden Erfindung liegt die Aufgabe zugrunde, eine verbesserte strukturierte Oberfläche bereitzustellen, mit der die Nachteile der herkömmlichen strukturierten Oberflächen überwunden werden. Des Weiteren liegt der Erfindung die Aufgabe zugrunde, ein mit einer derart verbesserten strukturierten Oberfläche ausgestattetes Bauteil bereitzustellen und ein verbessertes Verfahren zur Oberflächenmodifizierung vorzuschlagen.

Diese Aufgaben werden durch eine strukturierte Oberfläche, ein Bauteil und ein Verfahren mit den Merkmalen der unabhängigen Ansprüche gelöst. Vorteilhafte Ausführungsformen und Anwendungen der Erfindung ergeben sich aus den abhängigen Ansprüchen.

Vorrichtungsbezogen wird die Aufgabe gemäß einem ersten Gesichtspunkt der Erfindung durch die allgemeine technische Lehre gelöst, eine strukturierte Oberfläche bereitzustellen, die eine Trägerschicht und eine Vielzahl von Vorsprüngen umfasst und deren Eigenschaften gezielt veränderlich sind, so dass für eine durch die Vorsprünge gebildete Kontaktfläche eine vorbestimmte Haftfähigkeit in Bezug auf eine angrenzende Umgebung einstellbar ist. Erfindungsgemäß sind die Vorsprünge der strukturierten Oberfläche aus einem veränderlichen Material gebildet. Vorteilhafterweise kann damit durch eine Veränderung des Materials an sich und/oder seiner äußeren Form unmittelbar die Haftfähigkeit der Kontaktfläche eingestellt werden. Die Erfindung umfasst auch Varianten, bei denen die Vorsprünge und die Trägerschicht oder ausschließlich die Trägerschicht aus dem veränderlichen Material gebildet sind. Die Einstellung der Haftfähigkeit durch eine Veränderung der Trägerschicht kann bei bestimmten Anwendungen der strukturierten Oberfläche, Umgebungsbedingungen oder verwendeten Materialien von Vorteil sein.

Die veränderlichen Eigenschaften (Materialeigenschaften, Werkstoffeigenschaften) des erfindungsgemäß verwendeten Materials umfassen physikalische (einschließlich geometrische) und/oder chemische Eigenschaften des Materials an sich und/oder seiner äußeren Form. Die Eigenschaften sind gezielt veränderlich, das heißt durch eine physikalische und/oder chemische Einwirkung gerichtet veränderlich. Bei Veränderung einer Eigenschaft der Vorsprünge und/oder der Trägerschicht werden diese von einem ersten physikalisch und/oder chemisch definierten Zustand in einen zweiten, veränderten Zustand überführt (geschaltet). Die'Veränderlichkeit der Eigenschaften wird auch als Schaltbarkeit bezeichnet.

Die Kontaktfläche, die durch die freien Enden der Vorsprünge der erfindungsgemäßen strukturierten Oberfläche gebildet und entsprechend durch die Abstände zwischen den freien Enden unterbrochen ist, hat eine Haftfähigkeit, die durch das gezielte Schalten der Eigenschaften der Vorsprünge und/oder Trägerschicht einstellbar ist. Der Begriff "Haftfähigkeit" bezeichnet die Stärke der molekularen Wechselwirkungskräfte, die von der Kontaktfläche in Bezug auf eine angrenzende Umgebung, insbesondere einen angrenzenden Festkörper oder eine angrenzende Flüssigkeit gebildet werden können. Durch die Haftfähigkeit (Haftung) werden die Gegenkräfte zu mechanischen Kräften bestimmt, die zur Relativbewegung der Kontaktfläche und eines angrenzenden Objekts aufgewendet werden. Die Haftung umfasst Gegenkräfte mit Komponenten senkrecht und/oder parallel zur Oberfläche der Kontaktfläche. Entsprechend umfasst der Begriff Haftfähigkeit im Rahmen des vorliegenden Beschreibung sowohl die Adhäsionsfähigkeit als auch die Fähigkeit zur Erzeugung von Reibungskraft.

Die erfindungsgemäße strukturierte Oberfläche hat den Vorteil, dass durch das Schalten der Materialeigenschaft der Vorsprünge und/oder der Trägerschicht die Haftfähigkeit der Kontaktfläche von einem Zustand mit hoher Haftung in einen Zustand mit geringer Haftung (oder umgekehrt) umschaltbar ist. Entsprechend kann die Haftfähigkeit der Kontaktfläche in Abhängigkeit einer konkreten Anforderung, wie z. B. zur Aufnahme eines Werkstücks oder zur Ablage eines Werkstücks verändert werden, ohne dass äußere mechanische Trennkräfte auf die strukturierte Oberfläche oder das Werkstück ausgeübt werden müssen. Der Anwendungsbereich strukturierter Oberflächen wird damit erheblich erweitert, wobei bisherige Anwendungen der strukturierten Oberflächen deutlich vereinfacht werden, da auf Vorkehrungen zur Ausübung von Trennkräften verzichtet werden kann.

Gemäß einem weiteren Gesichtspunkt basiert die Erfindung auf der allgemeinen technischen Lehre, ein Bauteil mit verstellbarer Haftfähigkeit bereitzustellen, das die erfindungsgemäße strukturierte Oberfläche gemäß dem ersten Gesichtspunkt aufweist. Vorteilhafterweise kann die Trägerschicht der strukturierten Oberfläche ein Teil des Bauteils sein, das heißt die Vorsprünge der strukturierten Oberfläche können unmittelbar aus dem Material eines Basiskörpers des Bauteils gebildet sein. Alternativ kann die strukturierte Oberfläche schichtförmig auf einem Basiskörper des Bauteils angeordnet sein. Vorteilhafterweise kann somit ein bestehendes Objekt mit der strukturierten Oberfläche nachgerüstet werden, um das Objekt mit einer einstellbaren Haftfähigkeit auszustatten.

Gemäß einem weiteren Gesichtspunkt basiert die Erfindung auf der allgemeinen technischen Lehre, eine strukturierte Oberfläche durch eine gezielte Veränderung von Eigenschaften von Vorsprüngen und/oder einer Trägerschicht der Oberfläche zur Einstellung einer vorbestimmten Haftfähigkeit einer durch die Vorsprünge gebildeten Kontaktfläche zu modifizieren. Durch eine vorbestimmte äußere Einwirkung werden physikalische (einschließlich geometrische) und/oder chemische Eigenschaften der Vorsprünge und/oder der Trägerschicht variiert. Im Unterschied zu herkömmlichen strukturierten Oberflächen, bei denen eine Haftung oder Enthaftung durch eine äußere mechanische Kraft verursacht wird, die an dem haftenden Objekt oder dem Bauteil mit der strukturierten Oberfläche angreift, wird beim erfindungsgemäßen Verfahren die strukturierte Oberfläche als solche unmittelbar beeinflusst.

Die erfindungsgemäße strukturierte Oberfläche weist eine Vielzahl von Vorsprüngen auf, welche die Kontaktfläche der Oberfläche bilden. Mit dem Begriff "Vorsprung" werden langgestreckte Strukturen, z. B. mit Stab- oder Filamentform bezeichnet, die auf der Trägerschicht stehen. In Abhängigkeit von dem Verfahren zur Herstellung der strukturierten Oberfläche können die Trägerschicht und die Vorsprünge aus einem gemeinsamen Material oder aus verschiedenen Materialien hergestellt sein. Die Vorsprünge bilden eine mikro- oder nanostrukturierte Topografie, d. h. die Vorsprünge haben typischerweise eine axiale Länge im Bereich von 10 nm bis mehrere mm, z. B. 5 mm und eine radiale Dimension im Bereich von wenigen nm, z. B. 2 nm bis 1 mm. Die Vorsprünge bilden eine Faseranordnung, deren Haftfähigkeit durch eine äußere Einwirkung, die eine Veränderung insbesondere von geometrischen, mechanischen oder chemischen Eigenschaften der Faseranordnung bewirkt, von einem haftenden Zustand zu einem nicht-haftenden Zustand (oder umgekehrt) eingestellt werden kann.

Erfindungsgemäß können alle Vorsprünge die gleiche Form und Größe aufweisen. Alternativ können die Vorsprünge eine hierarchische Größenverteilung, z. B. wie sie in WO 03/099951 A2 beschrieben ist, Eigenschaftsgradienten und/oder Eigenschaftsanisotropien aufweisen. Ein Eigenschaftsgradient umfasst z. B. einen Gradienten im Young-Modul, mit dem die Vorsprünge an die Trägerschicht angrenzend eine größere Härte aufweisen als an ihren Kopfteilen. Eine Eigenschaftsanisotropie ist z. B. gegeben, wenn die Vorsprünge in longitudinalen und transversalen Richtungen verschiedene Young-Module aufweisen.

Die Erfinder haben festgestellt, dass vorteilhafterweise zur Einstellung der Haftfähigkeit viele verschiedene Werkstoffeigenschaften geeignet und entsprechende gezielt veränderliche Materialen verfügbar sind. Eine erste Gruppe von gezielt veränderlichen Eigenschaften umfasst physikalische Eigenschaften, insbesondere mechanische und/oder geometrische Eigenschaften der Vorsprünge und/oder der Trägerschicht.

Vorzugsweise umfassen die Vorsprünge Materialien, deren Neigungswinkel im Bezug auf die Trägerschicht veränderlich ist. Der Neigungswinkel stellt vorteilhafterweise eine einfache geometrische Größe der Vorsprünge dar, mit der die Haftfähigkeit unmittelbar veränderlich ist. Es kann beispielsweise vorgesehen sein, dass alle Vorsprünge den gleichen Neigungswinkel aufweisen, der zwischen einem ersten Wert (Zustand einer erhöhten Haftfähigkeit) und einem zweiten Wert (Zustand einer in Bezug auf den ersten Zustand verminderten Haftfähigkeit) veränderlich ist. Alternativ kann vorgesehen sein, das die Vorsprünge lediglich im Zustand erhöhter Haftfähigkeit den gleichen Neigungswinkel, im Zustand verminderter Haftfähigkeit jedoch verschiedene Neigungswinkel aufweisen. In diesem Fall wird durch eine Veränderung der Verteilung von Neigungswinkeln der Vorsprünge die Haftfähigkeit der strukturierten Oberfläche eingestellt. Diese Variante der Erfindung hat insbesondere Vorteile für eine graduelle Einstellung der Haftfähigkeit in Abhängigkeit von der Breite der Verteilung von Neigungswinkeln. Die Veränderung der Verteilung von Neigungswinkeln kann in einen komplett ungeordneten Zustand der Vorsprünge führen (so genannter Kollaps der strukturierten Oberfläche). Es ist vorzugsweise ein reversibler Kollaps der strukturierten Oberfläche vorgesehen.

Die Einstellung der Haftfähigkeit in Abhängigkeit vom Neigungswinkel kann in jedem konkreten Anwendungsfall ausgewählt werden, z. B. durch Versuche. Typischerweise steigt die Haftfähigkeit mit einem sich verringerndem Neigungswinkel. Alternativ kann bei Verringerung des Neigungswinkels eine verminderte Haftfähigkeit eingestellt werden, z. B. wenn die Vorsprünge mit verringertem Neigungswinkel besonders weich sind.

Vorteilhafterweise kann des weiteren eine Veränderung der Abstände zwischen den Vorsprünge insbesondere zwischen deren Kopfteilen, die unmittelbar die Kontaktfläche bilden, vorgesehen sein. Für diese Variante der Erfindung können beispielsweise verfügbare schrumpf- oder schwellfähige Materialien zur Bildung der Vorsprünge und/oder der Trägerschicht verwendet werden. Die Verwendung einer schrumpf- oder schwellfähigen Trägerschicht hat den Vorteil, dass durch eine relativ geringe äußere Einwirkung, wie z. B. eine Temperaturänderung oder eine Änderung der relativen Feuchte, eine starke Änderung der Abstände der Vorsprünge erzielt werden kann. Die Haftfähigkeit der Kontaktfläche kann mit besonders hoher Empfindlichkeit eingestellt werden. Wenn eine Einstellung des Elastizitätsmoduls der Vorsprünge und/oder von dessen Richtungsabhängigkeit vorgesehen ist, kann vorteilhafterweise die Haftfähigkeit der Kontaktfläche verändert werden, ohne das sich deren optischen Eigenschaften, wie z. B. das visuelle Erscheinungsbild, verändern.

Bei weiteren vorteilhaften Varianten der Erfindung kann eine gezielte Änderung von chemischen Eigenschaften der Vorsprünge und/oder der Trägerschicht vorgesehen sein. Die Erfinder haben festgestellt, dass organische Materialien (insbesondere Polymermaterialien), Kompositmaterialien oder Metalle verfügbar sind, bei denen durch eine äußere Einwirkung die Molekülstruktur, Festkörperstruktur (insbesondere Polymerstruktur) und/oder chemische Zusammensetzung derart gezielt veränderlich sind, dass sich die Fähigkeit der Vorsprünge zu molekularen Wechselwirkungen im Bezug auf unmittelbar angrenzende Objekte, insbesondere die Oberflächenadsorption verändert.

Ein weiterer wichtiger Vorteil der Erfindung besteht darin, dass eine Vielzahl verschiedener äußerer Einwirkungen verfügbar ist, die zur Modifizierung der strukturierten Oberfläche und zur Einstellung der Haftfähigkeit anwendbar sind. Eine äußere Einwirkung kann z. B. eine Temperaturänderung durch eine Erwärmung oder Abkühlung umfassen. Vorteilhafterweise kann eine Erwärmung durch eine Heizeinrichtung erreicht werden, die von außen, z. B. mittels Wärmestrahlung, oder von innen, z. B. mittels Induktionsheizung wirkt. Alternativ oder zusätzlich können statische oder dynamische magnetische und/oder elektrische Felder oder elektromagnetische Strahlung als äußere Einwirkung angewendet werden. Diese Variante hat insbesondere bei Anwendungen der Erfindung Vorteile, bei denen die strukturierte Oberfläche, ein mit dieser ausgestattetes Bauteil oder ein an diese angrenzendes Objekt temperaturempfindlich ist. Des Weiteren können magnetische und/oder elektrische Felder besonders vorteilhaft für eine reversible Einstellung der Haftfähigkeit verwendet werden. Schließlich kann die äußere Einwirkung eine Beaufschlagung der strukturierten Oberfläche mit mindestens einer chemischen Substanz umfassen. In diesem Fall kann vorteilhafterweise eine unbeabsichtigte Verstellung der Haftfähigkeit, z. B. durch Störfelder vermieden werden.

Die Vorsprünge und/oder die Trägerschicht der strukturierten Oberfläche weisen einen Elastizitätsmodul vorzugsweise unterhalb von 10 GPa auf. Dies hat insbesondere den Vorteil einer leichten Anpassung der strukturierten Oberfläche an glatte oder raue Oberflächen eines angrenzenden, an der Kontaktfläche haftenden Objekts. Vorteilhafterweise kann die Kontaktfläche somit im haftenden Zustand passend zur Oberfläche des angrenzenden Objekts geformt werden. Einen ausreichend geringen Elastizitätsmodul weisen z. B. organische Polymermaterialien auf. Alternativ können die Vorsprünge und/oder die Trägerschicht aus einem Metall gebildet sein. Es können insbesondere Metalle (so genannte Shape-Memory-Metalle, z. B. Nickel-Titan, siehe Y. Zhang et al. in "Appl. Phys. Lett." Bd. 89, 2006, S. 041912) verwendet werden.

Wenn die Vorsprünge einen Härtegradienten aufweisen, beträgt das Elastizitätsmodul an die Trägerschicht angrenzend z. B. 10 GPa und an den Kopfteilen z. B. 1 GPa. Wenn die Vorsprünge anisotrope Young-Module aufweisen, beträgt der Young-Modul in longitudinaler Richtung der Vorsprünge z. B. 1 GPa und in transversaler Richtung z. B. 10 MPa.

Gemäß einer weiteren Alternative können die Vorsprünge der erfindungsgemäßen strukturierten Oberfläche aus einem Material mit einem höheren Elastizitätsmodul, z. B. einer Keramik oder einem Halbleitermaterial gebildet sein, wenn die strukturierte Oberfläche zur Haftung an Objekten mit glatten Oberflächen vorgesehen ist und oder wenn die Trägerschicht mit einem Elastizitätsmodul unterhalb von 10 GPa gebildet ist. Im letzteren Fall kann eine Haftung an glatten oder rauen Oberflächen vorteilhafterweise auch dann erreicht werden, wenn die Vorsprünge aus einem härteren Material gebildet sind.

Wenn gemäß einer besonders bevorzugten Ausführungsform der Erfindung die Vorsprünge und/oder die Trägerschicht aus einem Polymermaterial gebildet sind, können sich weitere Vorteile aus der Vielzahl verfügbarer Polymere und deren Fähigkeit zur Anpassung an konkrete Anforderungen einer Anwendung der strukturierten Oberfläche ergeben. Es kann insbesondere ein einheitliches (homogenes) Polymermaterial, eine Polymerzusammensetzung aus verschiedenen Polymeren oder ein Polymerkomposit aus mindestens einem polymeren und einem Fremdstoff, wie z. B. Metallpartikeln verwendet werden. Polymerkomposite haben den weiteren Vorteil, dass geeignete Zusammensetzungen aus verfügbaren Polymeren, die zur Herstellung strukturierter Oberflächen geeignet sind (Verfahren siehe z. B. WO 03/099951 A2) mit metallischen oder magnetischen Zusätzen ausgestattet werden können, um die erfindungsgemäße Einstellbarkeit der Haftfähigkeit zu erreichen.

Als Polymermaterialien haben sich insbesondere Formgedächtnis-Polymere, Flüssigkristall-Polymere, Komposite mit metallischen, nicht-magnetischen oder mit magnetischen Partikeln, strahlenempfindliche Polymere und flüssigkeitsempfindliche Polymere als vorteilhaft erwiesen. Die Polymermaterialien sind z. B. aus Elastomeren oder Block-Copolymeren gebildet. Formgedächtnis-Polymere sind Polymere, die den Formgedächtnis-Effekt zeigen (siehe z. B. A. Lendlein et al. in "Angewandte Chemie - International Edition", Band 41, 2002, S. 2034-2057, R. Mohr et al. in "PNAS", Band 103, 2006, S. 3540-3545). Flüssigkristall-Polymere (siehe z. B. K. Hiraoka et al. in "Macromolecules" Band 38, 2005, S. 7352-7357) können vorteilhafterweise zur Einstellung der Haftfähigkeit unter Einwirkung elektrischer Felder verwendet werden. Strahlenempfindliche Polymere umfassen insbesondere lichtempfindliche Polymere, die ihre Gestalt oder Struktur bei Bestrahlung mit Licht (IR, VIS oder UV) ändern (siehe A. Lendlein et al. in "Nature", Band 434, 2005, S. 879-882). Erfindungsgemäß verwendete Polymermaterialien können zu mehreren der genannten Gruppen gehören.

Wenn die Eigenschaften der Vorsprünge und/oder der Trägerschicht gemäß einer bevorzugten Ausführungsform der Erfindung reversibel und wiederholt veränderlich sind, kann die Haftfähigkeit der strukturierten Oberfläche vorteilhafterweise wiederholt zwischen einem Zustand erhöhter Haftung und einem Zustand verminderter Haftung umgeschaltet werden. In diesem Fall ergeben sich besondere Vorteile für die Anwendung der strukturierten Oberfläche bei dynamischen Vorgängen, bei denen die Haftfähigkeit jeweils an konkrete Anforderungen eines Verfahrens angepasst werden soll. Alternativ kann eine einmalige, irreversible Einstellung der Haftfähigkeit vorgesehen sein. Eine einmalige Veränderung der Vorsprünge und/oder der Trägerschicht bedeutet, dass die Haftfähigkeit der strukturierten Oberfläche nach deren Herstellung, vorzugsweise unmittelbar vor der Anwendung nachträglich eingestellt wird.

Ein weiterer Vorteil der Erfindung besteht darin, dass die Vorsprünge an ihren freien Enden (Kopfteilen) eine oder mehrere Formen aufweisen können, die in Abhängigkeit von der konkreten Anwendung der strukturierten Oberfläche verschieden sein können. Es können beispielsweise Stirnflächen mit einer ebenen, sphärischen, gewölbten, oder abgeflachten Form oder Hohl- oder Napfstrukturen, wie Röhrchen, Saugnäpfe oder in Substrukturen aufgespaltene Formen vorgesehen sein.

Bevorzugte Anwendungen der Erfindung bestehen in der Transporttechnik, insbesondere in der Werkzeugtechnik und Robotertechnik, in der Bautechnik, in der Textiltechnik, insbesondere bei der Bildung von Textilverschlüssen, in der Medizintechnik, insbesondere für medizinische Geräte oder medizinisches Material, wie z. B. Verbandmaterial, für Sportartikel, wie z. B. Sportgeräte oder Sportschuhe, oder in der Haushaltstechnik, wie z. B. bei Möbeln.

Weitere Einzelheiten und Vorteile der Erfindung werden im Folgenden unter Bezug auf die beigefügten Zeichnungen beschrieben. Es zeigen:
- Figur 1:: eine erste Variante erfindungsgemäßer struktu- rierter Oberflächen mit einer Illustration der Einstellung der Haftfähigkeit;
- Figur 2:: schematische Schnittansichten von Vorsprüngen einer erfindungsgemäßen strukturierten Ober- fläche;
- Figuren 3 bis 7:: weitere Varianten erfindungsgemäßer struktu- rierter Oberflächen mit einer Illustration der Einstellung der Haftfähigkeit; und
- Figur 8:: eine schematische Illustration einer Anwendung der Erfindung in der Transporttechnik.

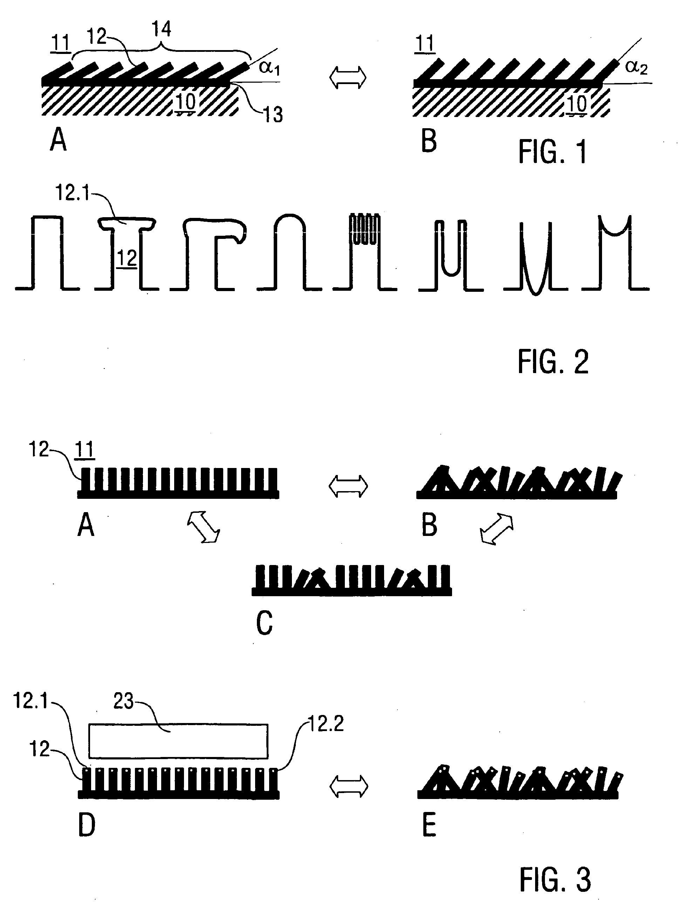

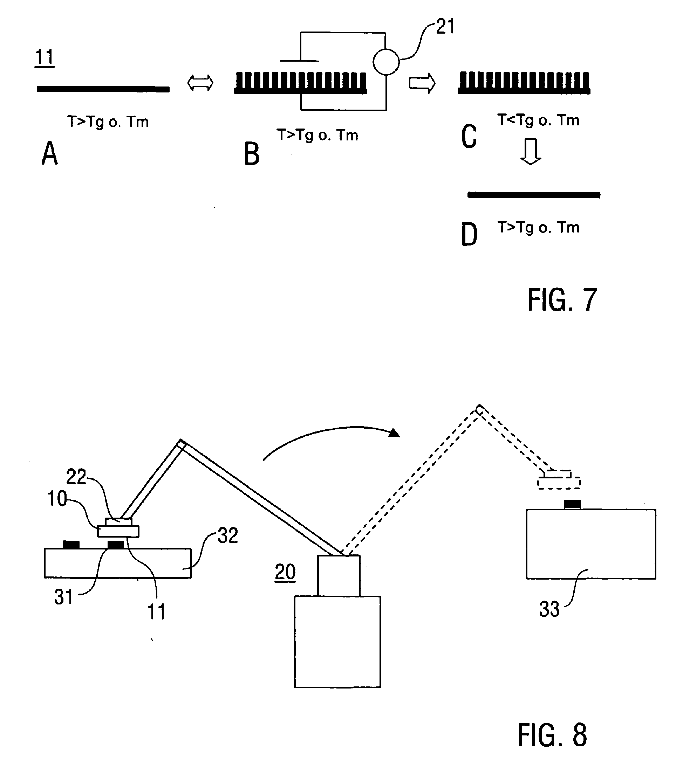

Verschiedene Wirkprinzipien der erfindungsgemäßen Einstellung der Haftfähigkeit werden im folgenden unter beispielhaftem Bezug auf die Figuren 1 bis 7 erläutert. Es wird betont, dass die Figuren lediglich der schematischen Illustration der Erfindung dienen. Die Umsetzung der Erfindung ist nicht auf die gezeigten geometrischen Formen und Größenverhältnisse der ausschnittsweise vergrößert dargestellten strukturierten Oberflächen beschränkt, sondern entsprechend mit abgewandelten geometrischen Verhältnissen umsetzbar (siehe z. B. Beschreibung von Figur 2, siehe auch WO 03/099951 A1). In den Figuren ist jeweils die strukturierte Oberfläche mit der Trägerschicht und den Vorsprüngen gezeigt. In der praktischen Umsetzung (siehe z. B. Figur 8) ist die strukturierte Oberfläche auf einem Basiskörper angeordnet oder als Bestandteil von diesem vorgesehen. Der Basiskörper kann eine gekrümmte oder ebene Oberflächenform aufweisen. Entsprechend kann die erfindungsgemäße strukturierte Oberfläche gekrümmt oder eben sein. Aus Übersichtlichkeitsgründen ist in den Figuren 2 bis 6 der Basiskörper nicht dargestellt.

In der folgenden Beschreibung werden zunächst Ausführungsbeispiele der gezielten, permanenten oder temporären Veränderung der erfindungsgemäßen strukturierten Oberfläche erläutert. Anschließend werden die Materialien und Verfahren zur Herstellung der erfindungsgemäßen strukturierten Oberfläche beispielhaft beschrieben. Es wird betont, dass in Abhängigkeit von den konkreten Bedingungen der Anwendung der strukturierten Oberfläche die verschiedenen Materialen zur Realisierung der verschiedenen Wirkprinzipien zur gezielten Einstellung der Haftfähigkeit verwendbar sind. Die beschriebenen Wirkprinzipien können verwendet werden, um auf einer Oberfläche eine einheitliche Haftfähigkeit einzustellen oder einen Gradienten der Haftfähigkeit zu bilden.

Figur 1A zeigt eine erste Ausführungsform der erfindungsgemäßen strukturierten Oberfläche 11 eines Basiskörpers 10, die eine Vielzahl von Vorsprüngen 12 auf einer Trägerschicht 13 aufweist. Die Vorsprünge 12 bilden eine regelmäßige Anordnung mit Abständen z. B. im Bereich von 10 nm bis 1 mm. Durch die Gesamtheit der freien Enden (Kopfteile) der Vorsprünge 12 wird eine Kontaktfläche 14 aufgespannt. Die Kontaktfläche 14 ist dazu eingerichtet, bei Berührung einer Oberfläche eines angrenzenden Objekts molekulare Wechselwirkungskräfte zu bilden. In Abhängigkeit von der Stärke der Gesamtheit der molekularen Wechselwirkungskräfte kann eine Haftverbindung zum angrenzenden Objekt gebildet werden. Die Haftverbindung wird ohne eine Verankerung mit der Oberfläche des Objekts oder ein Ineinandergreifen von Vorsprüngen gebildet, sondern durch van der Waals-Kräfte, gegebenenfalls unterstützt durch Kapillar-und/oder Saugkräfte (siehe Figur 2) vermittelt. Zusätzliche Beiträge können durch elektrostatische Kräfte oder Kapillarkräfte gebildet werden. Figur 2 zeigt beispielhaft verschiedene Varianten der Vorsprünge 12 mit Kopfteilen 12.1, die z. B. eine ebene (insbesondere flache, spatelförmige, T-förmige oder L-förmige), gewölbte (insbesondere sphärische), hohle oder aufgespaltene Gestalt aufweisen.

Die Vorsprünge 12 der erfindungsgemäßen strukturierten Oberfläche 11 werden vorzugsweise nach einem der folgenden Verfahren hergestellt: Mikro- oder Nanolithographie der Trägerschicht, Mikro-Printing, Wachstum der Vorsprünge durch Selbstorganisation, insbesondere von Block-Copolymeren, Mikro-Funkenerosion (bei metallischen Materialien), Mikro-EDM, Oberflächenbearbeitung mittels fokussiertem Ionenstrahl, plastisches Formen, z. B. Heißprägen oder Spritzguss und/oder sogenanntes Rapid Prototyping unter Verwendung von Laserstrahlen (mit Pulver- oder Polymermaterialien). Da diese Verfahren an sich bekannt sind, werden weitere Einzelheiten der Verfahrenstechnik hier nicht beschrieben. Zur Herstellung der Vorsprünge 12 aus Polymermaterial werden für die genannten Verfahren Polymerpulver, Polymerpellets oder Polymer-Precursor-Materialien verwendet, die gegebenenfalls ein Vernetzungsmittel und/oder ein Verstärkungsmittel enthalten. Das Vernetzungsmittel dient einer Vernetzung unter der Wirkung chemischer Substanzen oder unter der Wirkung von Bestrahlung, so dass die mechanische Stabilität der Vorsprünge verbessert werden kann.

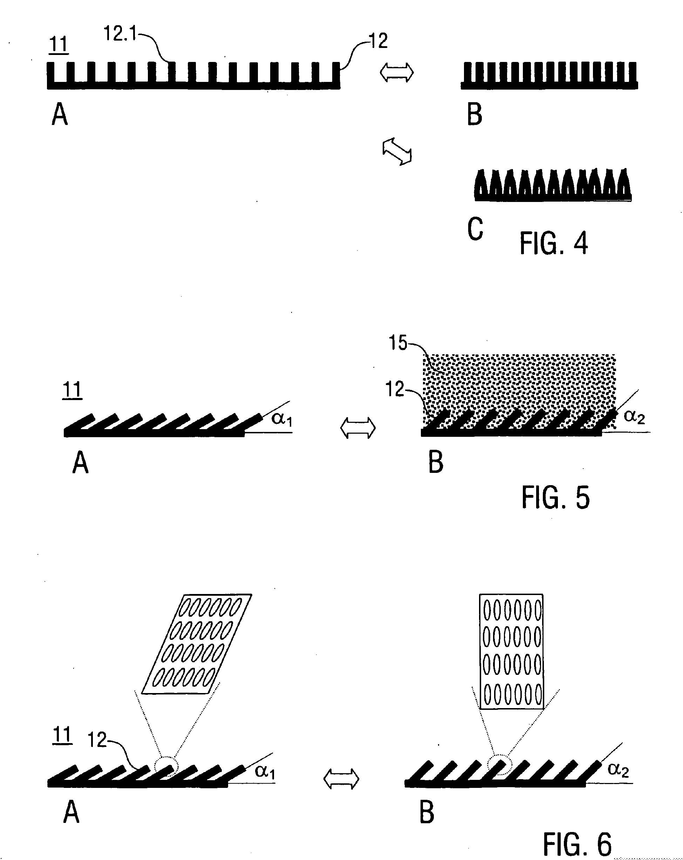

Die molekularen Wechselwirkungskräfte, die von der Kontaktfläche 14 gebildet werden, können in Abhängigkeit vom Neigungswinkel α zwischen einer Längsrichtung der Vorsprünge 12 und der Trägerschicht 13 eingestellt werden. Beispielsweise ergibt sich mit Polymervorsprüngen (Material: PDMS, Durchmesser: 10 µm, Länge: 50 µm) bei einem geringen Neigungswinkel α₁ = 30° (Figur 1A) ein Zustand mit erhöhter Haftfähigkeit und bei einem Neigungswinkel α₂ = 45° (Figur 1B) ein im Vergleich zum ersten Zustand veränderter Zustand verminderter Haftfähigkeit. Die Einstellung der Haftfähigkeit gemäß Figur 1 kann alternativ so erfolgen, dass bei dem geringen Neigungswinkel eine verminderte Haftfähigkeit und bei dem größeren Neigungswinkel eine erhöhte Haftfähigkeit oder umgekehrt gegeben ist. Das Umschalten zwischen dem haftenden und nicht-haftenden Zustand erfolgt durch eine äußere Einwirkung, die durch den Doppelpfeil symbolisiert ist und zum Beispiel eine Temperaturerhöhung, elektrische Felder, magnetische Felder, elektromagnetische Strahlung, insbesondere Licht, einen mechanischen Einfluss (z. B. eine mit einer Walze aufgebrachte Vorspannung) oder die Einwirkung chemischer Substanzen umfasst (siehe Figuren 5, 6).

Alternativ kann mit der äußeren Einwirkung gemäß den Figuren 3A bis 3C oder 3D und 3E die Haftfähigkeit durch eine gezielte Änderung eines Ordnungszustands der Vorsprünge 12 eingestellt werden. Der Ordnungszustand der Vorsprünge 12 kann durch die Breite der Verteilung der Neigungswinkel relativ zur Trägerschicht 13 charakterisiert werden. Lediglich in einem Zustand, in dem die Vorsprünge 13 eine Anordnung mit einem geordneten Muster (z. B. Matrixmuster) bilden und sämtlich in die selbe Richtung weisen, ist ein Zustand erhöhter Haftfähigkeit gegeben.

Gemäß Figur 3A haben alle Vorsprünge 12 den selben Neigungswinkel, d.h. die Verteilungsbreite der Neigungswinkel ist extrem eng. Durch eine gezielte physikalische und/oder chemische Einwirkung können die Neigungswinkel von einigen (Figur 3C) oder allen (Figur 3B) Vorsprüngen 12 verändert werden. Mit einer zunehmenden Anzahl von Vorsprüngen, die von der homogenen Ausrichtung gemäß Figur 3A abweichen, vermindern sich die molekularen Wechselwirkungskräfte, die von der Gesamtheit der Vorsprünge 12 ausgeübt werden. Entsprechend kann die strukturierte Oberfläche 11 durch eine äußere Einwirkung vom Zustand mit erhöhter Haftfähigkeit (Figur 3A) gegebenenfalls über ein Zwischenzustand (Figur 3C) in einen Zustand verminderter Haftfähigkeit (Figur 3B) umgeschaltet werden.

Der Ordnungszustand der Vorsprünge 12 kann gemäß den Figuren 3D und 3E vorteilhafterweise mit Polymerkompositen mit magnetischen Partikeln eingestellt werden. Die magnetischen Partikel 12.2 sind in oder an den Kopfteilen 12.1 der Vorsprünge 12 angeordnet. Durch das Feld eines Magneten 23 (Permanentmagnet oder schaltbarer Elektromagnet) werden alle Vorsprünge 12 ausgerichtet, so dass der haftende Zustand eingestellt wird (Figur 3D). Durch Entfernung des Magneten 23 oder ein Abschalten des Elektromagneten wird das magnetische Feld beseitigt, so dass die Vorsprünge zufällig verteilt ausgerichtet sind und der nicht-haftende Zustand eingestellt wird (Figur 3E). Die gezeigte Verstellung der Haftfähigkeit ist vorteilhafterweise wiederholt umkehrbar (reversibel).

Gemäß einer weiteren Alternative können die Abstände der Kopfteile 12.1 der Vorsprünge 12 gezielt verändert werden, um die Haftfähigkeit der strukturierten Oberfläche 11 einzustellen. Beispielsweise kann gemäß Figur 4A vorgesehen sein, dass mit relativ großen Abständen der Kopfteile 12.1 (z.B. im Bereich von 100 nm bis 1 mm) eine geringe Haftfähigkeit gegeben ist. Durch eine äußere Einwirkung kann die Zahl der Kopfteile 12.1 und damit der mikroskopischen Kontakte pro Fläche vergrößert werden, so dass gemäß Figur 4B zunächst ein Zustand erhöhter Haftfähigkeit erreicht wird. Anschließend kann durch die weitere äußere Einwirkung ein laterales Zusammenhaften der Vorsprünge 12 induziert werden, so dass sich die Haftfähigkeit der strukturierten Oberfläche 11 vermindert (Figur 4C).

Die Abstände zwischen den Kopfteilen 12.1 und damit die Haftfähigkeit der Kontaktfläche 14 können beispielsweise durch eine Erwärmung der Trägerschicht 13 eingestellt werden. Mit der Temperaturerhöhung schrumpft die Trägerschicht, so dass sich die Abstände der Kopfteile 12.1 verringern. Vorteilhafterweise ist dies möglich, ohne dass sich die Trägerschicht von einem Basiskörper ablöst. Sobald ein kritischer Abstand unterschritten wird, haften die Vorsprünge 12 lateral aneinander (Figur 4C), so dass die Haftfähigkeit vermindert oder bis zu einer Abstoßungswirkung verändert wird. Eine Trägerschicht aus einem schrumpffähigen Material wird vorzugsweise bei Ausführungsformen der Erfindung verwendet, bei denen sich die Größe des Bauteils, das mit der erfindungsgemäßen strukturierten Oberfläche ausgestattet ist, während der Anwendung ändert, z. B. durch eine Ausdehnung oder Kontraktion als Ergebnis einer Temperaturänderung. Mit der Anpassung der Trägerschicht an die veränderte Größe kann gleichzeitig die Haftfähigkeit der Oberfläche eingestellt werden.

Für eine Verminderung der Haftfähigkeit gemäß Figur 4C werden die Vorsprünge vorzugsweise aus einem Polymermaterial mit starker lateraler Adhäsion, insbesondere aus einem weichen Elastomer, z. B PDMS gebildet. Von dem Zustand verminderter Haftfähigkeit ausgehend kann durch eine Abkühlung der strukturierten Oberfläche eine Verminderung der lateralen Adhäsion der Vorsprünge erreicht werden, so dass sich die einzelnen Vorsprünge voneinander trennen (Übergang zur Anordnung gemäß Figur 4B). In diesem Zustand ist eine erhöhte Haftfähigkeit der Kontaktfläche 14 eingestellt.

Figur 5 zeigt das entsprechende Umschalten zwischen einem Zustand erhöhter Haftfähigkeit (Figur 5A) und einem Zustand verminderter Haftfähigkeit (Figur 5B) durch eine Beaufschlagung der strukturierten Oberfläche 11 mit einer chemischen Substanz 15 in Form einer Flüssigkeit oder eines Gases oder Dampfes, z. B. mit Wasser. Durch eine Umgebungsfeuchte wird Wasser an den Vorsprüngen 12 adsorbiert, so dass sich die Haftfähigkeit wie gezeigt durch eine Deformation der Vorsprünge, oder alternativ oder zusätzlich durch eine chemische Umwandlung im Material der Vorsprünge oder auf deren Oberfläche verändert. Bei Einwirkung der chemischen Substanz 15 kann beispielsweise der Neigungswinkel der Vorsprünge 12 konstant bleiben, die Adsorptionsfähigkeit ihrer Oberflächen hingegen verändert werden.

Einzelheiten der Einstellung der Haftfähigkeit unter Verwendung von Vorsprüngen aus flüssigkristallinen Elastomeren sind analog zu Figur 1 in Figur 6 am Beispiel der Veränderung der Neigungswinkel der Vorsprünge 12 illustriert. Die flüssigkristallinen Elastomere weisen bei einem Phasenübergang von einer isotropen zu einer nematischen oder smektischen Phase eine Verlängerung oder eine Schrumpfung entlang der Mesogene in Domänenbereichen auf. Die Verlängerung oder Schrumpfung tritt während des Phasenübergangs spontan und schnell auf, wie in den schematisch vergrößerten Teildarstellungen von Figur 5 gezeigt ist. Der Phasenübergang kann durch eine äußere Einwirkung ausgelöst werden, die zum Beispiel eine Temperaturänderung oder ein elektrisches Feld umfasst. Es ist zum Beispiel eine Temperaturänderung um wenige Grad, z. B. +/- 10° um die Übergangstemperatur, bei welcher der Übergang zwischen der nematischen und smektischen Phase oder eine Isotropisierung erfolgen, oder die Bildung eines elektrischen Feldes mit einer Feldstärke einigen V/µm, z. B. von 10 V/µm oder 10⁷ V/m vorgesehen.

Die Haftfähigkeit der strukturierten Oberfläche 11 kann gemäß einer weiteren Alternative mit einem Polymermaterial eingestellt werden, dass zur Bildung einer strukturierten Oberfläche in einem äußeren elektrischen Feld eingerichtet ist. Der Vorgang der elektrisch induzierten Strukturierung ist reversibel, so dass die Haftfähigkeit zwischen verschiedenen Zuständen umschaltbar ist. Gemäß Figur 7 kann das Umschalten der strukturierten Oberfläche unter der Wirkung eines elektrischen Feldes mit einer Temperaturänderung kombiniert werden, um Eigenschaften der Vorsprünge auch nach Abschalten des elektrischen Feldes zu erhalten. Beispielsweise wird gemäß den Figuren 7A und 7B bei einer Temperatur oberhalb der Glasübergangstemperatur oder der Schmelztemperatur des Polymermaterials der elektrisch induzierte Übergang vom Zustand ohne Haftfähigkeit (Figur 7A) zum Zustand mit Haftfähigkeit (Figur 7B) durchgeführt. Das mit einer äußeren Spannungsquelle 21 induzierte elektrische Feld hat beispielsweise eine Feldstärke von 10 V/cm. Durch Abkühlung der strukturierten Oberfläche 11 unterhalb der Glasübergangs- oder Schmelztemperatur (Figur 7C) kann der Zustand mit erhöhter Haftfähigkeit zunächst auch ohne das elektrische Feld erhalten werden. Durch eine Erwärmung der strukturierten Oberfläche 11 auf eine Temperatur oberhalb der Glasübergangs- oder Schmelztemperatur kann die Haftfähigkeit auf einen verminderten Wert eingestellt werden (Figur 7D). Die in Figur 7 illustrierte Ausführungsform der Erfindung ist mit besonderem Vorteil insbesondere in der Transporttechnik, speziell in der Halbleitertechnologie und Mikroelektronik anwendbar.

Zur Erzeugung des elektrischen Feldes für die z. B. in den Figuren 1, 3 oder 7 gezeigten Ausführungsformen der Erfindung wird die Spannungsquelle 21 mit einer unteren Elektrode unterhalb der Vorsprünge und einer oberen Elektrode oberhalb der Vorsprünge verbunden. Die untere Elektrode wird vorzugsweise durch eine elektrisch leitfähige Komponente des Bauteils gebildet, das die strukturierte Oberfläche trägt, wie z. B. durch eine elektrisch leitfähige Schicht in einem elektronischen Bauteil. Die obere Elektrode wird vorzugsweise durch ein Teil eines Zusatzwerkzeuges, wie eines Transportwerkzeugs gemäß Figur 8, gebildet. Die Position der oberen Elektrode bestimmt die Richtung des elektrischen Feldes, dem die strukturierte Oberfläche ausgesetzt wird. Vorzugsweise sind beide Elektroden flächig gebildet und mit konstantem Abstand, insbesondere parallel, zur strukturierten Oberfläche angeordnet.

Im Folgenden werden Materialien beschrieben, die zur Bildung erfindungsgemäßer strukturierter Oberflächen geeignet sind.

### 1. Polymere mit Formgedächtnis

Um die verschiedenen Haftfähigkeiten der strukturierten Oberfläche einzustellen und die Übergänge zwischen den verschiedenen Eigenschaften der Vorsprünge 12 und/oder Trägerschichten 13 zu induzieren, werden können Polymere mit Formgedächtnis verwendet werden. Die Vorsprünge werden beispielsweise bei einer Temperatur nahe oder oberhalb der Glasübergangstemperatur oder der Schmelztemperatur einer mechanischen Spannung ausgesetzt, ohne die Elastizitätsgrenze des Materials zu überschreiten. Das unter der mechanischen Spannung kollabierte Muster der Vorsprünge (z. B. Figur 3B) kann beispielsweise durch eine Erhitzung des Materials oberhalb der Glasübergangs- oder Schmelztemperatur in die ursprüngliche Anordnung (z. B. Figur 3A) überführt werden. In Abhängigkeit von der Zuordnung des permanenten oder transienten Zustands zu einem der Zustände des Polymermaterials können die folgenden Materialien zur Herstellung schaltbarer strukturierter Oberflächen verwendet werden:

### 1.1 Polymermaterialien mit einem vernetzten permanenten Zustand und einem amorphen oder glasartigen transienten Zustand

Erfindungsgemäß können lineare oder verzweigte Polymere, Polymerzusammensetzungen oder Polymerkomposite (z. B. auf der Basis von Polymethylmethacrylat (PMMA), Polyvinylchlorid (PVC), Polyurethan (PU), Polynorbornen) mit einer physikalischen Vernetzung oder Verschränkung, die eine elastische Deformation ermöglicht. Vernetzte elastomere Materialen werden besonders bevorzugt, da sie eine stärkere elastische Deformation ermöglichen.

Beispielsweise kann eine adhäsive, regelmäßig gebildete Kontaktfläche (Figur 3A) durch mechanische Kräfte in den kollabierten, nicht-adhäsiven Zustand (Figur 3B) deformiert und auf eine Temperatur unterhalb der Glasübergangstemperatur abgekühlt werden, um den nicht-adhäsiven Zustand mit der kollabierten Anordnung der Vorsprünge 12 zu fixieren. Im Fall einer elastischen Deformation, wird die Spannung freigegeben, wenn die Temperatur oberhalb der Glasübergangstemperatur erhöht wird und die kollabierte Anordnung wird in die ursprüngliche geordnete Anordnung übergehen. Entsprechend kann an der Kontaktfläche durch die Temperaturerhöhung die erhöhte Haftfähigkeit wieder hergestellt werden.

### 1.2 Polymermaterialien mit einem vernetzten permanenten Zustand und einem semikristallinen transienten Zustand

Erfindungsgemäß können Polymere, Polymerzusammensetzungen oder Polymerkomposite verwendet werden, die eine Fähigkeit zur partiellen Kristallisation aufweisen, wie zum Beispiel trans-Polyimid (PI), vernetztes Polyethylen (PE) oder thermoplastische Elastomere.

Beispielsweise wird eine geordnete Anordnung der Vorsprünge 12 gemäß Figur 3A mit dem vernetzten Polymer gebildet. Durch die Vernetzung wird die Form der Vorsprünge (Zustand mit erhöhter Haftfähigkeit) gespeichert. Um in den Zustand mit verminderter Haftfähigkeit (Figur 3B) zu gelangen, wird eine mechanische (elastische) Deformation bei einer Temperatur oberhalb der Schmelztemperatur des vernetzten Anteils der Vorsprünge 12 ausgeführt. Für Polymere wie zum Beispiel vernetztes trans-PI oder PE wird die Deformation bei einer Temperatur von zum Beispiel 80 °C ausgeführt. Der Zustand mit verminderter Haftfähigkeit ist in diesem Fall der transiente Zustand, der durch die mikrokristallinen Teile fixiert wird, die im Polymer während des Abkühlvorgangs gebildet werden. Um die erhöhte Haftfähigkeit einzustellen (Figur 3A), wird die strukturierte Oberfläche auf eine Temperatur oberhalb der Schmelztemperatur des vernetzten Anteils des Polymers erwärmt. Die Temperaturerhöhung erfolgt unterhalb einer Obergrenze, bei der ein lateraler Kollaps der Vorsprünge drohen würde.

### 1.3 Gemischte Polymerzusammensetzungen oder phasengetrennte Block-Copolymere mit einer glasartigen und einer semikristallinen Komponente

Erfindungsgemäß können lineare Block-Copolymere, wie zum Beispiel Polystyrol-Poly(1-buten) (PS-PB) oder PU, mit harten und weichen Bestandteilen, oder Polyethylenterephthalat-Poly(ethylenoxid) (PET-PEO), zur Bildung der Vorsprünge 12 verwendet werden. Der permanente Zustand (z. B. Figur 3A) wird durch den glasartigen Zustand von einer der Komponenten (z. B. PS, oder harter Bestandteil von PU, oder PET) gespeichert. Der transiente Zustand (Figur 3B) wird durch eine Deformation bei einer Temperatur oberhalb der Schmelztemperatur der zweiten Komponente und ein anschließendes Abkühlen derart erreicht, dass die Kristalle eine mikrokristalline Struktur fixieren. Entsprechend wird die verminderte Haftfähigkeit eingestellt. Die Schmelztemperatur der phasengetrennten Block-Copolymere liegt zum Beispiel im Bereich von 40°C bis 60°C. Eine Wärmezufuhr zur Temperaturerhöhung bewirkt ein Schmelzen der mikrokristallinen Bereiche, so dass der ursprüngliche Zustand mit erhöhter Haftfähigkeit (Figur 3A) eingestellt wird.

### 1.4 Gemischte Polymerzusammensetzungen oder phasengetrennte Block-Copolymere mit zwei glasartigen Komponenten

Gemäß einer weiteren Alternative können Block-Copolymere oder Polymermischungen verwendet werden, die zwei glasartige Komponenten zur Einstellung verschiedener Formen der Vorsprünge und damit verschiedener Haftfähigkeiten enthalten. Die Vorsprünge 12 können zum Beispiel aus PU mit harten und weichen Bestandteilen, wie zum Beispiel Methylenbis(4-phenylisocyanat) oder Bisphenol A als harter Bestandteil und methylenische oder oxymethylenische Ketten als weicher Bestandteil, gebildet sein. In diesem Fall wird der permanente Zustand (Figur 3A) durch den glasartigen Zustand von einer der Komponenten (z. B. dem harten Bestandteil von PU gespeichert. Der transiente Zustand (Figur 3B) wird durch eine Deformation bei einer Temperatur oberhalb der Glasübergangstemperatur der zweiten Komponente und eine abschließende Abkühlung derart erreicht, dass der glasartige Zustand der zweiten Komponente fixiert wird. Die Glasübergangstemperatur der zweiten Komponente liegt zum Beispiel im Bereich von 15°C bis 60°C. Die erhöhte Haftfähigkeit wird durch eine Erwärmung der strukturierten Oberfläche oberhalb der Glasübergangstemperatur der zweiten (weichen) Komponente eingestellt.

### 2. Flüssigkristalline Elastomere

Erfindungsgemäß können nematische oder smektische flüssigkristalline Elastomere zur Bildung der Vorsprünge 12 der erfindungsgemäßen strukturierten Oberfläche 11 verwendet werden. Die Einstellung der Haftfähigkeit unter Verwendung dieser Polymergruppe ist in Figur 6 am Beispiel der Veränderung der Neigungswinkel der Vorsprünge 12 illustriert. Beispiele für derartige Polymere, die ein biaxiales Formgedächtnis aufweisen, werden zum Beispiel von K. Hiraoka et al. in "Macromole-cules" Band 38, 2005, S. 7352-7357 beschrieben.

### 3. Schrumpf- und schwellfähige Polymermaterialien

Zur Einstellung der Haftfähigkeit der strukturierten Oberfläche 11 entsprechend der in den Figuren 4A und 4B gezeigten Variante kann ein schrumpf- und schwellfähiges Polymermaterial, z.B. auf der Basis von Polyethylen, oder einem Mehrschichtmaterial, z. B. aus biaxial orientiertem PE, PP, Fluoropolymeren oder mehreren Schichten PE geringer Dichte, verwendet werden. Geeignete Polymermaterialien sind beispielsweise aus der Verpackungstechnik bekannt.

### 4. Polymerkomposite, die metallische, nicht-magnetische Partikel enthalten

Wenn eine Einstellung der Haftfähigkeit durch eine Temperaturerhöhung vorgesehen ist und das mit der strukturierten Oberfläche 11 ausgestattete Bauteil oder ein angrenzendes Objekt für eine direkte Erwärmung nicht geeignet sind, werden Polymermaterialien zum Beispiel gemäß 1. bis 3. verwendet, die mit metallischen, nicht-magnetischen Partikeln beladen sind. Diese Polymerkomposite erlauben eine induktive Heizung, die vorteilhafterweise unmittelbar auf die strukturierte Oberfläche 11 lokalisiert ist und Schäden am Bauteil oder den angrenzenden Objekt vermeidet. Die induktive Heizung von Polymerzusammensetzungen wird beispielsweise von Mohr et al. in "PNAS", Band 103, 2006, S. 3540-3545 beschrieben.

### 5. Magnetische Polymermaterialien

Eine weitere Variante zur Einstellung der Haftfähigkeit insbesondere bei temperaturempfindlichen Systemen besteht in der Verwendung von Polymerkompositen mit magnetischen Partikeln oder magnetischen Polymeren oder Polymerzusammensetzungen zur Bildung der Vorsprünge. Beispielsweise können Polymere, denen magnetische Partikel, z. B. aus Magnetit oder Metalloxidkomplexen zugesetzt sind, oder als inherent magnetisches Polymermaterial Polyacetylen oder Zusammensetzungen mit alternierend sich wiederholenden Einheiten aus Polyenen und Arenen, die in Meta-Position gekoppelt sind, verwendet werden.

Erfindungsgemäß kann beispielsweise vorgesehen sein, dass das Polymermaterial mit magnetischen Eigenschaften im feldfreien Zustand die permanente Form mit erhöhter Haftfähigkeit aufweist. Zur Einstellung einer verminderten Haftfähigkeit kann ein Magnetfeld eingeschaltet werden, unter dessen Wirkung sich beispielsweise die Neigungswinkel der Vorsprünge 12 (Figur 1) ändert. Alternativ kann der permanente Zustand unter der Wirkung eines vorhandenen Magnetfelds eingestellt sein, wobei in diesem Fall zur Einstellung der Haftfähigkeit das vorhandene Magnetfeld im Bezug auf die Intensität und/oder Richtung geändert wird.

Gemäß einer weiteren Alternative kann die Wirkung des Magnetfeldes an einen thermischen Übergang gekoppelt sein, wie er oben unter 1.1 beschrieben wurde. In diesem Fall kann die Einstellung der Haftfähigkeit nicht nur in Abhängigkeit von der Stärke und/oder Richtung des Magnetfeldes, sondern auch in Abhängigkeit von der Temperatur der Vorsprünge eingestellt werden.

Zur Erzeugung des magnetischen Feldes für die z. B. in den Figuren 1, 3 oder 7 gezeigten Ausführungsformen der Erfindung wird z. B. ein Permanentmagnet als Teil eines Zusatzwerkzeuges, wie eines Transportwerkzeugs gemäß Figur 8, verwendet.

### 6. Polare Polymermaterialien

Erfindungsgemäß können die Vorsprünge 12 und/oder die Trägerschicht 13 der strukturierten Oberfläche 11 aus einem Polymermaterial gebildet sein, das zu einer Ausrichtung von Polymerketten in Reaktion auf ein äußeres elektrisches Feld eingerichtet ist (polares Polymermaterial). Das Polymermaterial enthält z. B. Dipole, die sich im äußeren elektrischen Feld ausrichten können. Mit polaren Polymermaterialien können beispielsweise die folgenden Varianten realisiert werden.

### 6.1 Elastomer mit flüssigkristallinen Eigenschaften

Unter der Wirkung eines elektrischen Feldes können, wie in Figur 6 beispielhaft illustriert ist, flüssigkristalline Elastomere oder Elastomere mit einem flüssigkristallinen Zusatz, die nematische oder smektische Mesophasen aufweisen, eine mesogene Reorientierung und Neigung in Abhängigkeit vom elektrischen Feld aufweisen. Geeignete Polymermaterialien sind beispielsweise Polymere auf der Grundlage von Siloxan, Acrylat oder Methylenether mit flüssigkristallinen Seitenketten oder kettenförmige Polymere mit einem flüssigkristallinen Zusatz geringen Molekulargewichts. Mit Monodomänen geeigneter Größe (vorzugsweise entsprechend dem Vorsprungsquerschnitt, z. B. im Bereich von 10 nm³ bis einige µm³), wirkt sich eine Kettenreorientierung in einer Änderung der äußeren Geometrie des Polymermaterials aus. Vorteilhafterweise ist dieser Vorgang reversibel und mit der Stärke und/oder Richtung des elektrischen Feldes aktivierbar bzw. steuerbar.

### 6.2 Selbstorganisierende Polymerschichten

Die Haftfähigkeit der strukturierten Oberfläche 11 kann gemäß Figur 7 mit einem Polymermaterial eingestellt werden, dass zur spontanen Bildung einer strukturierten Oberfläche in Abhängigkeit von einem äußeren elektrischen Feld eingerichtet ist (selbstorganisierendes Polymermaterial). Geeignete Polymermaterialien werden beispielsweise von T. Thurn-Albrecht et al. in "Macromolecules", Band 33, 2000, S. 3250 - 3253 be-schrieben.

### 7. Strahlenempfindliche Polymermaterialien

Die erfindungsgemäße Veränderung der Vorsprünge einer strukturierten Oberfläche kann eine strahleninduzierte, insbesondere lichtinduzierte geometrische Änderung der Struktur eines Elastomeren oder eines flüssigkristallinen Elastomeren oder eines Polymers mit einem strahlenempfindlichen Zusatz umfassen. Durch die Bestrahlung können chemische oder physikalische Eigenschaften des Polymermaterials verändert werden. Derartige Veränderungen umfassen zum Beispiel eine Aktivierung oder Freigabe von lichtempfindlichen, vernetzenden Molekülen in dem Polymermaterial, eine Änderung von Dipolmomenten, Konformationsänderungen, Änderungen der intermolekularen Wechselwirkungen oder chemische Reaktionen (z.B. Vernetzung). Durch die Bestrahlung kann sich die Geometrie der Vorsprünge, z. B. durch eine Schrumpfung/Ausdehnung, eine Verbiegung oder eine Verdrehung der Vorsprünge ändern.

### 7.1 Polymere mit Photoisomeren

Eine erfindungsgemäße Veränderung von Vorsprüngen der strukturierten Oberfläche kann eine Isomerisierung umfassen. Beispielsweise können Konformationsänderungen von photoisomeresierbaren Vernetzungseinheiten durch eine Bestrahlung induziert werden. Die Bestrahlung erfolgt mit einer Wellenlänge, die in Abhängigkeit von dem Absorptionsverhalten des Polymers, beispielsweise im UV-, VIS- oder IR-Bereich gewählt. Es kann beispielsweise eine cis-trans-Photoisomerisierung von Azobenzen durch eine Bestrahlung bei 365 nm oder 436 nm vorgesehen sein. Der Isomerisierungsvorgang bewirkt eine Längenreduzierung von Polymerketten. Beispielsweise erfolgt in der Azobenzeneinheit eine Längenreduzierung der Ketten von 0,9 nm auf 0,55 nm. Alternativ können Konformationsänderungen in Spirooxazinen oder Chromenen vorgesehen sein. Durch die Konformationsänderung werden Vernetzungen zwischen Ketten aufgebaut, durch die in Abhängigkeit von der Bestrahlung eine Ausdehnung oder ein Schrumpfen des Polymers induziert werden kann.

### 7.2 Polymermaterialien mit Photodimeren

Analog zu 7.1 kann durch eine strahlungsinduzierte Dimerisierung eine Schrumpfung ausgelöst werden. Beispielsweise kann in einem Polymer, das cinnamatische Gruppen enthält, die Teil der Polymerkette sind, eine Bestrahlung eine Dimerisierung oder Vernetzung induzieren.

### 7.3 Polymer mit lichtinduzierter Ladungserzeugung

Erfindungsgemäß können die Vorsprünge der strukturierten Oberfläche mit einem Polymermaterial gebildet sein, das einen Zusatz enthält, der zur Ladungstrennung bei Bestrahlung eingerichtet ist. Der Zusatz umfasst beispielsweise Triphenylmethan-Leuco-Derivate, welche bei Bestrahlung mit UV-Licht in Ionenpaare dissoziieren. Durch die bestrahlungsinduzierten Ladungen kann es in den Vorsprüngen zu einer elektrostatischen Abstoßung kommen, die eine makroskopische Ausdehnung oder Schrumpfung des Materials bewirkt. Entsprechend kann die Form oder Ausrichtung der Vorsprünge (siehe z. B. Figuren 1 oder 3) durch eine Bestrahlung verändert und entsprechend die Haftfähigkeit der erfindungsgemäßen strukturierten Oberfläche eingestellt werden.

### 7.4 Polymere mit Formgedächtnis

Gemäß einer weiteren Variante können die Vorsprünge der strukturierten Oberfläche aus Polymeren mit Licht-induziertem Formgedächtnis gebildet sein, wie sie beispielsweise von A. Lendlein et al. in "Nature", Band 434, 2005, S. 879-882, oder in "Adv. Mat.", Band 18, 2006, S. 1471-1475 beschrieben sind.

### 8. Polymermaterialien mit veränderlicher Elastizität

Die Haftfähigkeit der erfindungsgemäßen strukturierten Oberfläche kann durch eine Änderung des Young-Moduls des Materials der Vorsprünge und/oder der Trägerschicht moduliert werden. Durch eine Veränderung der Elastizität kann eine verendete Haftfähigkeit eingestellt werden. Die Haftfähigkeit steigt mit der Weichheit des Materials der Vorsprünge und/oder der Trägerschicht. Der Young-Modul kann beispielsweise durch eine Temperaturänderung oder die Gegenwart einer chemischen Substanz, wie zum Beispiel eines Lösungsmittels oder Wassers verändert (vergrößert oder verkleinert) werden. Durch die Gegenwart eines Lösungsmittels oder von Luftfeuchte kann beispielsweise der Young-Modul von hygroskopischen Polymeren oder Gelen, z. B. Polyacrylamid oder Polyether, verändert werden (Figur 5).

### 9. Polymermaterialien mit veränderlicher Oberflächenenergie

Durch die Gegenwart von Lösungsmitteln oder Wasser oder durch eine Temperaturänderung können Polymere mit veränderlicher Oberflächenenergie, wie zum Beispiel phasengetrennte Polymere (Blockpolymere, Polymermischungen) in ihren physikalischen oder chemischen Eigenschaften verändert werden. Polymerketten, die an der Oberfläche des Materials liegen, werden bei einer Änderung der Phasenkompatibilität der Bestandteile dieser Polymere in Abhängigkeit von der Temperatur, einem Lösungsmittel oder Wasser verändert. Im Ergebnis kann sich die Haftfähigkeit der Oberfläche vergrößern oder verkleinern. Diese Veränderungen können mit mechanischen Veränderungen zum Beispiel durch eine Veränderung der Mikrostruktur des Polymermaterials kombiniert werden.

### Anwendungen der Erfindung

Figur 8 illustriert beispielhaft eine Anwendung der Erfindung in der Transporttechnik. Ein erfindungsgemäßes Bauteil 10 mit einer strukturierten Oberfläche 11 ist an einem Transportwerkzeug 20 angeordnet. Das Transportwerkzeug 20 ist mit einer Schalteinrichtung 22 ausgestattet, mit der physikalische und/oder chemische Änderungen der strukturierten Oberfläche 11 bewirkt werden können. Mit der Transporteinrichtung 20 können Objekte, wie zum Beispiel Werkstücke 31 von einer ersten Arbeitsstation 32 zu einer zweiten Arbeitsstation 33 transportiert werden.

Der Transportvorgang umfasst beispielsweise die folgenden Schritte. Zunächst wird das Transportwerkzeug 20 zu der ersten Arbeitsstation 32 bewegt. Mit der Schalteinrichtung 22 wird eine erhöhte Haftfähigkeit der strukturierten Oberfläche 11 eingestellt. Das Bauteil 10 wird an das Objekt 31 angenähert, bis die Kontaktfläche der strukturierten Oberfläche 11 die Oberfläche des Objekts 31 berührt. Durch molekulare Wechselwirkungskräfte wird eine Haftverbindung zwischen der strukturierten Oberfläche 11 und dem Objekt 31 erzeugt. Mit dem Transportwerkzeug 20 wird das Objekt 31 an die zweite Arbeitsstation 33 bewegt. An dieser wird die Schalteinrichtung 22 betätigt, so dass die verminderte Haftfähigkeit der strukturierten Oberfläche 11 eingestellt wird. Im Ergebnis wird das Objekt 31 freigegeben. Das Transportwerkzeug 20 kann zu weiteren Verfahrensschritten zur ersten Arbeitsstation zurückbewegt werden.

Entsprechende Anwendungen sind z. B. in der Bautechnik, der Medizintechnik und bei der Technik der Haushaltsartikel möglich.

Die in der vorstehenden Beschreibung, den Zeichnungen und den Ansprüchen offenbarten Merkmale der Erfindung können sowohl einzeln als auch in Kombination für die Verwirklichung der Erfindung in ihren verschiedenen Ausgestaltungen von Bedeutung sein.

## Patentansprüche

1. Strukturierte Oberfläche (11) eines Festkörpers (10), die umfasst:
- eine Vielzahl von Vorsprüngen (12), die eine Kontaktfläche (14) mit einer Haftfähigkeit in Bezug auf eine angrenzende Umgebung bilden, und
- eine Trägerschicht (13), auf der die Vorsprünge (12) angeordnet sind, wobei
- Eigenschaften der Vorsprünge (12) und/oder der Trägerschicht (13) derart gezielt veränderlich sind, dass die Haftfähigkeit der Kontaktfläche (14) einstellbar ist,
**dadurch gekennzeichnet, dass**
- die Haftfähigkeit durch molekulare Wechselwirkungskräfte von der Kontaktfläche auf die angrenzende Umgebung gebildet wird, und
- die Haftfähigkeit der Kontaktfläche (14) durch eine gerichtete Veränderung mindestens einer der chemischen Eigenschaften, die eine Molekülstruktur, eine Polymerstruktur, eine chemische Zusammensetzung und eine Oberflächenadsorption des Materials der Vorsprünge (12) umfassen, und/oder mindestens einer der physikalischen Eigenschaften, die einen Neigungswinkel der Vorsprünge (12), eine Verteilung von Neigungswinkeln der Vorsprünge (12), einen Abstand von Kopfteilen der Vorsprünge (12), ein Elastizitätsmodul der Vorsprünge (12), eine Richtungsabhängigkeit eines Elastizitätsmoduls der Vorsprünge (12) und einen Schrumpfungsgrad der Trägerschicht (13) umfassen, schaltbar ist.

2. Strukturierte Oberfläche nach Anspruch 1, bei der die Vorsprünge (12) und/oder die Trägerschicht (13) aus einem Material gebildet sind, das durch eine Temperaturänderung, ein magnetisches Feld, ein elektrisches Feld, elektromagnetische Strahlung, eine mechanische Kraftwirkung und/oder chemische Substanzen veränderlich ist.

3. Strukturierte Oberfläche nach mindestens einem der vorhergehenden Ansprüche, bei der die Vorsprünge (12) oder die Trägerschicht (13) aus einem Polymermaterial oder einem Metall gebildet sind.

4. Strukturierte Oberfläche nach Anspruch 3, bei der das Polymermaterial ein Formgedächtnis-Polymer, ein Flüssigkristall-Polymer, ein Polymerkomposit mit metallischen, nicht-magnetischen Partikeln, ein Polymerkomposit mit magnetischen Partikeln, ein strahlenempfindliches Polymer und/oder ein flüssigkeitsempfindliches Polymer umfasst.

5. Strukturierte Oberfläche nach mindestens einem der vorhergehenden Ansprüche, bei der die Eigenschaften der Vorsprünge (12) und/oder die Trägerschicht (13)
- reversibel und wiederholt veränderlich sind, oder
- irreversibel veränderlich sind.

6. Strukturierte Oberfläche nach mindestens einem der vorhergehenden Ansprüche, bei der die Vorsprünge (12)
- Stirnflächen (13) aufweisen, die in einem haftfähigen Zustand der Kontaktfläche (14) den gleichen senkrechten Abstand von der Trägerschicht (11) haben,
- eine Hohl- oder Napfstruktur aufweisen, die in einem haftfähigen Zustand der Kontaktfläche (14) eine Saugwirkung bildet.

7. Strukturierte Oberfläche nach mindestens einem der vorhergehenden Ansprüche, bei der die Haftfähigkeit der Kontaktfläche (14) einen Gradienten bildet.

8. Bauteil, das mit einer strukturierten Oberfläche nach mindestens einem der vorhergehenden Ansprüche ausgestattet ist.

9. Bauteil nach Anspruch 8, bei dem die Trägerschicht der strukturierten Oberfläche integraler Bestandteil eines Basiskörpers des Bauteils oder schichtförmig auf dem Basiskörper angeordnet ist.

10. Verwendung einer strukturierten Oberfläche oder eines Bauteils nach mindestens einem der vorhergehenden Ansprüche:
- in der Transporttechnik,
- in der Bautechnik,
- in der Medizintechnik,
- in der Textiltechnik,
- in der Sportartikeltechnik, oder
- in der Haushaltsartikeltechnik.

11. Verfahren zur Modifizierung einer strukturierten Oberfläche (11) eines Festkörpers (10), die eine Vielzahl von Vorsprüngen (12), die eine Kontaktfläche (14) mit einer Haftfähigkeit in Bezug auf eine angrenzende Umgebung bilden, und eine Trägerschicht (13) aufweist, auf der die Vorsprünge (12) angeordnet sind, wobei
- eine gezielte Veränderung von Eigenschaften der Vorsprünge (12) und/oder der Trägerschicht (13) derart vorgesehen ist, dass eine vorbestimmte Haftfähigkeit der Kontaktfläche (14) eingestellt wird
**dadurch gekennzeichnet, dass**
- die Haftfähigkeit durch molekulare Wechselwirkungskräfte von der Kontaktfläche auf die angrenzende Umgebung gebildet wird, und
- die Haftfähigkeit der Kontaktfläche (14) durch eine gerichtete Veränderung mindestens einer der chemischen Eigenschaften, die eine Molekülstruktur, eine Polymerstruktur, eine chemische Zusammensetzung und eine Oberflächenadsorption des Materials der Vorsprünge (12) umfassen, und/oder mindestens einer der physikalischen Eigenschaften, die einen Neigungswinkel der Vorsprünge (12), eine Verteilung von Neigungswinkeln der Vorsprünge (12), einen Abstand von Kopfteilen der Vorsprünge (12), ein Elastizitätsmodul der Vorsprünge (12), eine Richtungsabhängigkeit eines Elastizitätsmoduls der Vorsprünge (12) und einen Schrumpfungsgrad der Trägerschicht (13) umfassen, geschaltet wird.

12. Verfahren nach Anspruch 11, bei dem
- die Vorsprünge (12) und/oder die Trägerschicht (13), einer Temperaturänderung, einem magnetischen Feld, einem elektrischen Feld, elektromagnetischer Strahlung, einer mechanischen Kraftwirkung und/oder einer chemischen Substanz ausgesetzt werden.

13. Verfahren nach mindestens einem der Ansprüche 11 bis 12, bei dem die Veränderung der Eigenschaften der Vorsprünge (12) und/oder der Trägerschicht (13)
- reversibel ist und wiederholt wird, oder
- irreversibel ist.

14. Verfahren nach mindestens einem der Ansprüche 11 bis 13, bei dem eine Einstellung eines Gradienten der Haftfähigkeit der Kontaktfläche (14) vorgesehen ist.

## Claims

1. A structured surface (11) of a solid body (10), which comprises:
- a multiplicity of projections (12), which form a contact area (14) with adhesion relative to adjacent surroundings, and
- a carrier layer (13), on which the projections (12) are arranged, wherein
- properties of the projections (12) and/or of the carrier layer (13) are specifically variable in such a way that the adhesion of the contact area (14) is adjustable,
**characterized in that**
- the adhesion is formed by molecular interaction forces of the contact area to the adjacent surroundings, and
- the adhesion is switchable by a targeted variation of at least one of the chemical properties which include a molecular structure, a polymer structure, a chemical composition and a surface adsorption of the material of the projections (12), and/or at least one of the physical properties which include an angle of inclination of the projections (12), a distribution of angles of inclination of the projections (12), a distance between head parts of the projections (12), a modulus of elasticity of the projections (12), a direction-dependence of a modulus of elasticity of the projections (12) and a degree of shrinkage of the carrier layer (13).

2. The structured surface according to claim 1, in which the projections (12) and/or the carrier layer (13) are formed of a material which is variable by a change in temperature, a magnetic field, an electric field, electromagnetic radiation, a mechanical force effect and/or chemical substances.

3. The structured surface according to at least one of the preceding claims, in which the projections (12) or the carrier layer (13) are formed of a polymer material or a metal.

4. The structured surface according to claim 3, in which the polymer material comprises a shape memory polymer, a liquid crystal polymer, a polymer composite with metallic, non-magnetic particles, a polymer composite with magnetic particles, a radiation-sensitive polymer and/or a liquid-sensitive polymer.

5. The structured surface according to at least one of the preceding claims, in which the properties of the projections (12) and/or the carrier layer (13) are variable reversibly and repeatedly, or are variable irreversibly.

6. The structured surface according to at least one of the preceding claims, in which the projections (12) have
- end faces (13) which in an adhesive state of the contact area (14) are at the same vertical distance from the carrier layer (11),
- a hollow or cupped structure which in an adhesive state of the contact area (14) forms a suction effect.

7. The structured surface according to at least one of the preceding claims, in which the adhesion of the contact area (14) forms a gradient.

8. A component which is provided with a structured surface according to at least one of the preceding claims.

9. The component according to claim 8, in which the carrier layer of the structured surface forms an integral part of a base body of the component or is arranged in layer form on the base body.

10. The use of a structured surface or of a component according to at least one of the preceding claims:
- in transport technology,
- in construction technology,
- in medical technology,
- in textile technology,
- in sports equipment technology, or
- in household equipment technology.

11. A method for modifying a structured surface (11) of a solid body (10) which comprises a multiplicity of projections (12), which form a contact area (14) with adhesion relative to adjacent surroundings, and a carrier layer (13), on which the projections (12) are arranged, wherein
- specifically varying properties of the projections (12) and/or of the carrier layer (13) is provided in such a way that a predefined adhesion of the contact area (14) is set,
**characterized in that**
- the adhesion is formed by molecular interaction forces of the contact area to the adjacent surroundings, and
- the adhesion is switched by a targeted variation of at least one of the chemical properties which include a molecular structure, a polymer structure, a chemical composition and a surface adsorption of the material of the projections (12), and/or at least one of the physical properties which include an angle of inclination of the projections (12), a distribution of angles of inclination of the projections (12), a distance between head parts of the projections (12), a modulus of elasticity of the projections (12), a direction-dependence of a modulus of elasticity of the projections (12) and a degree of shrinkage of the carrier layer (13).

12. The method according to claim 11, in which
- the projections (12) and/or the carrier layer (13) are exposed to a change in temperature, a magnetic field, an electric field, electromagnetic radiation, a mechanical force effect and/or a chemical substance.

13. The method according to at least one of claims 11 to 12, in which the variation of the properties of the projections (12) and/or of the carrier layer (13) is reversible and is carried out repeatedly, or is irreversible.

14. The method according to at least one of claims 11 to 13, in which a setting of a gradient of the adhesion of the contact area (14) is provided.

## Revendications

1. Surface structurée (11) d'un solide (10), laquelle surface comprend :
- une pluralité de saillies (12) qui forment une surface de contact (14) ayant un pouvoir d'adhérence vis-à-vis d'un milieu environnant, et
- une couche support (13) sur laquelle les saillies (12) sont disposées,
- des propriétés des saillies (12) et/ou de la couche support (13) pouvant être modifiées de manière ciblée afin de permettre l'ajustement du pouvoir d'adhérence de la surface de contact (14),
**caractérisée en ce que**
- le pouvoir d'adhérence est assuré par des forces d'interaction moléculaire de la surface de contact sur le milieu environnant, et
- le pouvoir d'adhérence de la surface de contact (14) peut être commuté par une modification dirigée de l'une au moins de ses propriétés chimiques, qui comprennent une structure moléculaire, une structure polymère, une composition chimique et une adsorption en surface du matériau des saillies (12), et/ou de l'une au moins de ses propriétés physiques, qui comprennent un angle d'inclinaison des saillies 112), une distribution des angles d'inclinaison des saillies (12), une distance entre les sommets des saillies (12), un module d'élasticité des saillies (12), une variation d'un module d'élasticité des saillies (12) en fonction de l'orientation, et un degré de retrait de la couche support (13).

2. Surface structurée selon la revendication 1, dans laquelle les saillies (12) et/ou la couche support (13) sont faites d'un matériau qui peut être modifié par une variation de température, un champ magnétique, un champ électrique, un rayonnement électromagnétique, une force mécanique et/ou des substances chimiques.

3. Surface structurée selon l'une au moins des revendications précédentes, dans laquelle les saillies (12) ou la couche support (13) sont faites d'un matériau polymère ou d'un métal.

4. Surface structurée selon la revendication 3, dans laquelle le matériau polymère comprend un polymère à mémoire de forme, un polymère à cristaux liquides, un composite polymère contenant des particules métalliques amagnétiques, un composite polymère contenant des particules métalliques magnétiques, un polymère sensible à un rayonnement et/ou un polymère sensible à un liquide.

5. Surface structurée selon l'une au moins des revendications précédentes, dans laquelle les propriétés des saillies (12) et/ou la couche support (13)
- sont modifiables de manière réversible et répétée, ou
- sont modifiables de manière irréversible.

6. Surface structurée selon l'une au moins des revendications précédentes, dans laquelle les saillies (12)
- présentent des faces frontales (13) qui, dans un état adhérent de la surface de contact (14), ont la même distance par rapport à la couche support (11),
- présentent une structure à creux ou cupules qui crée un effet de succion dans un état adhérent de la surface de contact (14).

7. Surface structurée selon l'une au moins des revendications précédentes, dans laquelle le pouvoir d'adhérence de la surface de contact (14) forme un gradient.

8. Composant doté d'une surface structurée selon l'une au moins des revendications précédentes.

9. Composant selon la revendication 8, dans lequel la couche support de la surface structurée fait partie intégrante d'un corps de base du composant ou est disposée en couche sur le corps de base.

10. Utilisation d'une surface structurée ou d'un composant selon l'une au moins des revendications précédentes :
- dans la technique du transport et de la manutention,
- dans la technique de la construction,
- dans la technique biomédicale,
- dans la technique textile,
- dans la technique des articles de sport, ou
- dans la technique des articles ménagers.

11. Procédé de modification d'une surface structurée (11) d'un solide (10) qui présente une pluralité de saillies (12), qui forment une surface de contact (14) ayant un pouvoir d'adhérence vis-à-vis d'un milieu environnant, et une couche support (13) sur laquelle les saillies (12) sont disposées, dans lequel
- il est prévu une modification ciblée de propriétés des saillies (12) et/ou de la couche support (13) de façon à ajuster un pouvoir d'adhérence prédéterminé de la surface de contact (14),
**caractérisé en ce que**
- le pouvoir d'adhérence est formé par des forces d'interaction moléculaire de la surface de contact sur le milieu environnant, et
- le pouvoir d'adhérence de la surface de contact (14) est commuté par une modification dirigée de l'une au moins de ses propriétés chimiques, qui comprennent une structure moléculaire, une structure polymère, une composition chimique et une adsorption en surface du matériau des saillies (12), et/ou de l'une au moins de ses propriétés physiques, qui comprennent un angle d'inclinaison des saillies 112), une distribution des angles d'inclinaison des saillies (12), une distance entre les sommets des saillies (12), un module d'élasticité des saillies (12), une variation d'un module d'élasticité des saillies (12) en fonction de l'orientation, et un degré de retrait de la couche support (13).

12. Procédé selon la revendication 11, dans lequel
- les saillies (12) et/ou la couche support (13) sont exposées à une variation de température, un champ magnétique, un champ électrique, un rayonnement électromagnétique, une force mécanique et/ou une substance chimique.

13. Procédé selon l'une au moins des revendications 11 à 12, dans lequel la modification des propriétés des saillies (12) et/ou de la couche support (13)
- est réversible et répétée, ou
- est irréversible.

14. Procédé selon l'une au moins des revendications 11 à 13, dans lequel il est prévu d'ajuster un gradient du pouvoir d'adhérence de la surface de contact (14).
